(19) Europäisches Patentamt

European Patent Office

Office européen des brevets

(11) **EP 4 712 322 A1**

(12) **EUROPEAN PATENT APPLICATION**

(43) Date of publication:
**18.03.2026   Bulletin 2026/12**

(21) Application number: **24199925.9**

(22) Date of filing: **12.09.2024**

(51) International Patent Classification (IPC):
*H02M 1/00* (2006.01)    *H02M 1/34* (2007.01)
*H02M 1/42* (2007.01)    *H02M 3/335* (2006.01)
*H05B 45/385* (2020.01)    *G01R 27/26* (2006.01)

(52) Cooperative Patent Classification (CPC):
**H02M 3/33523; H02M 1/0058; H02M 1/342;
H02M 1/4258; H02M 3/33592; H05B 45/385;
G01R 27/2611; G01R 31/40; H05B 45/355**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Tridonic GmbH & Co. KG
6851 Dornbirn (AT)**

(72) Inventor: **Stark, Stefan
6851 Dornbirn (AT)**

(74) Representative: **Beder, Jens
Mitscherlich PartmbB
Karlstraße 7
80333 München (DE)**

(54) **CONTROL UNIT AND METHOD FOR CONTROLLING A FLYBACK CONVERTER COMPRISING A POWER SWITCH AND AN ACTIVE CLAMP CIRCUIT HAVING A CLAMP SWITCH**

(57)    The present invention provides a control unit (1) for controlling a flyback converter comprising a power switch ($S_w$) and an active clamp circuit (3) having a clamp switch ($S_a$), wherein the control unit (1) is configured to switch the clamp switch ($S_a$) from the non-conducting state to the conducting state when a waiting time ($t_{off,HS}$) has elapsed after switching the power switch ($S_w$) from the conducting state to the non-conducting state, switch the power switch ($S_w$) from the conducting state to the non-conducting state when a current ($i_p$) flowing through the power switch ($S_w$) being in the conducting state reaches a maximum current value ($\hat{I}_p$), and compute the waiting time using an inductance of a primary winding (L1) of a transformer of the flyback converter, the maximum current value ($\hat{I}_p$), a winding ratio (n) of the transformer and an output voltage ($V_{out}$) of the flyback converter.

**Figure 1**

**Description**

The present invention relates to a control unit and method for controlling a flyback converter, the flyback converter comprising a power switch and an active clamp circuit having a clamp switch; an operating device comprising such a control unit and the flyback converter, and a lighting system comprising such an operating device and lighting means, such as one or more light emitting diodes (LEDs).

A flyback converter comprising an active clamp circuit on its primary side (the primary side being galvanically isolated from a secondary side of the flyback converter by a transformer of the flyback converter), the active clamp circuit comprising a clamp capacitor and clamp switch being electrically connected in series, may be used as a DC-to-DC converter as well as an AC-to-DC converter. Herein, the term "electrically connect" may be abbreviated by the term "connect". The active clamp circuit is electrically connected in parallel to a primary winding of the transformer being arranged on the primary side of the flyback converter, wherein a power switch is electrically connected in series to the primary winding of the transformer of the flyback converter. The power switch may be referred to as "flyback switch" or "main switch". By controlling switching of the power switch an electrical energy transfer from the primary winding of the transformer to a secondary winding of the transformer and, thus, from the primary side to the secondary side of the flyback converter may be controlled. The clamp capacitor of the active clamp circuit is configured to store leakage electrical energy of the transformer and when the clamp switch is in the conducting state (i.e. it is switched on) transfer the stored electrical energy to the secondary side. The time during which the clamp switch is in the conducting state may be referred to as "forward phase". The terms "clamping circuit", "clamping capacitor" and "clamping switch" may used as synonyms for the terms "clamp circuit", "clamp capacitor" and "clamp switch", respectively. Switching the clamp switch in the forward phase to the conducting state and, thus, discharging the clamp capacitor to transfer the previously stored leakage energy of the transformer from the primary winding to the secondary winding of the transformer and, thus, from the primary to the secondary side of the flyback converter causes a negative current flow on the primary side of the flyback converter. The negative current flow on the primary side is a current flow opposite to a positive current flow on the primary side, wherein the positive current flow is present, when the power switch is in the conducting state, while the clamp switch is in the non-conducting state (i.e. it is switched off). The negative current flow during the forward phase discharges an output capacitance of the power switch and, thus, enables zero voltage switching of the power switch. That is, the power switch may be switched to the conducting state while a voltage across the power switch is zero. Such zero voltage switching allows operation at higher frequencies and at higher voltages supplied at an input of the primary side of the flyback converter without a reduction in efficiency. In addition, zero current switching may be achieved. The power switch and clamp switch may be referred to as "low switch" and "high switch", respectively. The above described flyback converter may be referred to as clamp flyback converter or converter with active clamped flyback (ACF) topology.

For operating the flyback converter, the power switch and the clamp switch may be controlled such that they are not switched to the conducting state at the same time, i.e. they are not in the conducting state at the same. Once the power switch is switched from the non-conducting state to the conducting state and, thus, the current flowing through the primary winding rises, the power switch may be controlled to be switched from the conducting state to the non-conducting state when the current flowing through the primary winding and, thus, the power switch being in the conducting state reaches a maximum current value. For this, a control unit being arranged on the primary side for controlling the clamp switch and power switch being arranged on the primary side may obtain a measurement of the current flowing through the power switch. This may be implemented by connecting a resistor, e.g. a shunt resistor, in series with the powers switch and providing the voltage across the resistor to the control unit, the voltage being indicative of the current flowing through the resistor via Ohm's law. As soon as said voltage reaches a voltage corresponding to the maximum current value, the control unit may determine that the current through the power switch and, thus, the primary winding has reached the maximum current value and, thus, may control the power switch to switch from the conducting state to the non-conducting state. For this, the control unit may comprise a comparator comparing the voltage representing the current flowing through the power switch in the conducting state and a reference voltage representing the maximum current value.

The control unit should switch the clamp switch from the non-conducting state to the conducting state when the current flowing through the secondary winding of the transformer, which starts reducing when the power switch is switched from the conducting to the non-conducting state, reaches zero Amperes (0 A). This is necessary to achieve zero current switching of the clamp switch. In order to provide a zero voltage switching the time during which the clamp switch is in the conducting state and, thus, a negative current flows on the primary side is to be controlled. In case the control unit is a microcontroller, simple and low-cost microcontrollers cannot be used for achieving a measurement of the current flowing through the secondary winding. Namely, for this additional electrical components need to be provided on the secondary side for measuring the current flowing though the secondary winding on the secondary side and providing the measurements from the secondary side to the primary side via the galvanic isolation between the primary and secondary side.

Thus, it is an object of the present invention to allow operating the clamp switch of the clamp flyback converter such that no measurements are needed during operation of the flyback converter for a control of switching the clamp switch. It is in particular an object of the present invention to allow a simple and low in cost microcontroller without additional electrical components for measuring the current flowing through the secondary winding to be used as a control unit for controlling the power switch and clamp switch and, thus, operation of the clamp flyback converter.

These and other objects, which become apparent upon reading the following description, are solved by the subject-matter of the independent claim. The dependent claims refer to preferred embodiments of the invention.

According to a first aspect of the invention, a control unit for controlling a flyback converter is provided, the flyback converter comprising a power switch and an active clamp circuit having a clamp switch. The control unit is configured to switch the clamp switch from the non-conducting state to the conducting state when a waiting time has elapsed after switching the power switch from the conducting state to the non-conducting state. The control unit is configured to switch the power switch from the conducting state to the non-conducting state when a current flowing through the power switch being in the conducting state reaches a maximum current value. The control unit is configured to compute the waiting time using an inductance of a primary winding of a transformer of the flyback converter, the maximum current value, a winding ratio of the transformer and an output voltage of the flyback converter.

Thus, the first aspect of the invention proposes to compute a waiting time for the clamp switch of a clamp flyback converter, during which the clamp switch waits for switching from the non-conducting state to the conducting state, the waiting time starting at the point in time, at which the power switch switches from the conducting to the non-conducting state. In order to make sure that the waiting time is computed such that the waiting time ends when the current flowing through a secondary winding of the transformer of the flyback converter reaches zero Amperes (0 A), the control unit is configured to use the inductance of the primary winding of the transformer, the maximum current value, a winding ratio of the transformer and an output voltage of the flyback converter. The term "turn ratio" may be used as a synonym for the term "winding ratio". The control unit obtains the output voltage anyway for controlling the normal flyback operation, i.e. providing a certain output voltage by controlling a conversion of an input voltage at the primary side to the output voltage at the secondary side of the flyback converter by controlling switching of the power switch. Thus, according to the first aspect the control unit does not need to obtain a measurement of the current flowing through the secondary winding of the transformer of the flyback converter for achieving a zero current switching of the clamp switch. This allows using a simple and low in cost microcontroller as the control unit. The above description of the flyback converter and control of the flyback converter is correspondingly valid for the flyback converter being controlled by the control unit of the first aspect as well as describing how the control unit may be configured to control the power switch and the clamp switch.

The control unit may be or may comprise a microcontroller. In addition or alternatively, the control unit may be or may comprise at least one of a controller, a microprocessor, a processor, an application specific integrated circuit (ASIC) and a field programmable gate array (FPGA).

The control unit may be configured to compute the waiting time such that the waiting time equals a product of an inductance of the primary winding of the transformer and the maximum current value divided by a product of the winding ratio of the transformer and the output voltage of the flyback converter.

That is, the control unit may be configured to compute the waiting time using Farraday's inductance law. The inductance of the primary winding may equal to the magnetizing inductance of the primary winding. That is, the magnetizing inductance may be used as the inductance of the primary winding for computing the waiting time.

Optionally, the control unit is configured to switch the clamp switch from the conducting state to the non-conducting state when a switch-on time has elapsed after switching the clamp switch from the non-conducting state to the conducting state, and obtain (optionally select), in dependence of an input voltage and an output power of the flyback converter, the switch-on time from different switch-on times associated with pairs of different values of the input voltage and the output power.

Thus, the control unit does not need to perform additional measurements in addition to the normal control of the flyback function, i.e. electrical energy transfer from the primary side to the secondary side of the flyback converter (e.g. converting a voltage at the primary side to a second voltage at the secondary side of the flyback converter). Namely, the control unit obtains the input voltage and the output power of the flyback converter for the flyback function. That is, these parameters are already present. Optionally, the output current of the flyback converter may be used instead of the output power of the flyback converter. In this case, the description with regard to using the output power is correspondingly valid. The switch-on time may be referred to as "switch-on time of the clamp switch".

The different switch-on times associated with the pairs of different values of the input voltage and the output power may be obtained in advanced by measuring an optimal switch-on time for each of the pairs of different values of the input voltage and the output power, and/or

simulating an optimal switch-on time for each of the pairs of different values of the input voltage and the output power.

Optionally, at least one of the following is true: the control unit stores the different switch-on times associated with the pairs of different values of the input voltage and the output power; the control unit is configured to obtain from a data storage the different switch-on times associated with the pairs of different values of the input voltage and the output power; and the control unit is configured to compute, using a higher order equation, the switch-on time using the different switch-on times associated with pairs of different values of the input voltage and the output power.

For example, the control unit may be configured to access data, e.g. a graph, of multiple curves, wherein each curve is associated to a respective output power and shows for the respective output power a relationship between different values of the input voltages and the switch-on time. With regard to an output power of the data and, thus, the respective curve, the control unit may compute the switch-on time by making a best-fit of the data of the multiple curves. For example, the control unit may obtain the input voltage ($V_{in}$) and compute, using the data of the multiple curves, the switch-on time ($t_{on,Sa}$) with a second order equation

$$t_{on,Sa} = V_{in}^2 \times a + V_{in} \times b + c .$$ The parameters a, b and c are the results of a best fit calculation. The control unit may make a best fit between the multiple curves, i.e. between the different output powers associated to the multiple curves, respectively.

Optionally, the control unit is configured to determine the switch-on time based on the input voltage and the output power (or the output current instead of the output power) using an higher order equation.

Optionally, the control unit is configured to perform a power factor correction (PFC) function by changing the maximum current value such that a shape of an envelope of the changing maximum current value has a sinusoidal form of an input voltage of the flyback converter.

That is, the control unit allows a PFC function to be performed using the clamp flyback converter.

In order to achieve the control unit according to the first aspect of the present invention, some or all of the above described optional features may be combined with each other.

According to a second aspect of the invention, an operating device for lighting means is provided. The lighting means are optionally one or more light emitting diodes (LEDs). The operating device comprises a control unit according to the first aspect of the invention, as described above, and a flyback converter comprising a power switch and an active clamp circuit having a clamp switch. The control unit is configured to control switching of the power switch and the clamp switch of the flyback converter.

In case of multiple LEDs, the LEDs may be electrically connected in series and/or in parallel. The control unit and the flyback converter may be arranged inside a housing of the operating device.

The active clamp circuit may comprise a clamp capacitor, wherein the clamp capacitor and the clamp switch are electrically connected in series.

The power switch may be electrically connected in series with a primary winding of a transformer of the flyback converter, and the active clamp circuit is electrically connected with the primary winding of the transformer in parallel.

In order to achieve the operating device according to the second aspect of the present invention, some or all of the above described optional features may be combined with each other.

The above description with regard to the control unit according to the first aspect of the present invention is also valid for the operating device according to the second aspect of the present invention. The above description with regard to the operating device according to the second aspect of the present invention is also valid for the control unit according to the first aspect of the present invention.

The operating device according to the second aspect achieves the same advantages as the control unit according to the first aspect of the invention.

According to a third aspect of the invention, a lighting system is provided. The lighting system comprises an operating device according to the second aspect of the invention, as described above, and lighting means. The lighting means are optionally one or more light emitting diodes (LEDs). The operating device is configured to electrically supply the lighting means.

Optionally, the lighting system is a luminaire. The operating device and the lighting means may be arranged inside a housing of the luminaire. Optionally, the lighting means may be arranged at least partly outside the housing, e.g. protrude out of the housing.

The above description with regard to the operating device according to the second aspect of the present invention is also valid for lighting system according to the third aspect of the present invention.

The lighting system according to the third aspect achieves the same advantages as the control unit according to the first aspect of the invention.

According to a fourth aspect of the present invention, a method for controlling a flyback converter is provided. The flyback converter comprises a power switch and an active clamp circuit having a clamp switch. The method comprises switching the clamp switch from the non-conducting state to the conducting state when a waiting time has elapsed after switching the power switch from the conducting state to the non-conducting state. The method comprises switching the power switch from the conducting state to the non-conducting state when a current flowing through the power switch being in the conducting state reaches a maximum current value. The method comprises computing the waiting time using an inductance of a primary winding of a transformer of the flyback converter, the maximum current value, a winding ratio of the transformer and an output voltage of the flyback converter.

The method may comprise computing the waiting time such that the waiting time equals a product of an inductance of the primary winding of the transformer and the maximum current value divided by a product of the winding ratio of the transformer and the output voltage of the flyback converter.

The method may comprise switching the clamp switch from the conducting state to the non-conducting state when a switch-on time has elapsed after switching the clamp switch from the non-conducting state to the conducting state, and obtaining (optionally selecting), in dependence of an input voltage and an output power of the flyback converter, the switch-on time from different switch-on times associated with pairs of different values of the input voltage and the output power.

The method may comprise generating the different switch-on times associated with the pairs of different values of the input voltage and the output power by measuring an optimal switch-on time for each of the pairs of different values of the input voltage and the output power, and/or simulating an optimal switch-on time for each of the pairs of different values of the input voltage and the output power.

The method may comprise obtaining from a data storage the different switch-on times associated with the pairs of different values of the input voltage and the output power. The method may comprise computing, using a higher order equation, the switch-on time using the different switch-on times associated with pairs of different values of the input voltage and the output power.

The method may comprise performing a power factor correction (PFC) function by changing the maximum current value such that a shape of an envelope of the changing maximum current value has a sinusoidal form of an input voltage of the flyback converter.

In order to achieve the method according to the fourth aspect of the present invention, some or all of the above described optional features may be combined with each other.

The above description with regard to the control unit according to the first aspect of the present invention is also valid for the method according to the fourth aspect of the present invention. The above description with regard to the method according to the fourth aspect of the present invention is also valid for the control unit according to the first aspect of the present invention.

The method according to the fourth aspect achieves the same advantages as the control unit of the first aspect.

All steps which are performed by the various entities described in the present application as well as the functionalities described to be performed by the various entities are intended to mean that the respective entity is adapted to or configured to perform the respective steps and functionalities.

In the following, the invention is described exemplarily with reference to the enclosed figures (FIGs.), in which

**FIG. 1** shows an example of a control unit according to an embodiment of the invention for controlling a flyback converter and an example of such a flyback converter,

FIG. **2** shows an example of control signals provided by the control unit of FIG. 1 for controlling the flyback converter of FIG. 1 and currents and a voltage in the flyback converter caused by the control,

FIG. **3** shows an example of a current flowing through the primary winding and a current flowing through the secondary winding of the flyback converter of FIG. 1 during a part of a control cycle of switching the flyback converter.

FIG. **4** shows an example of different switch-on times of the clamp switch of the flyback-converter of FIG. 1 for different values of the output power and input voltage of the flyback converter

In the FIGs., corresponding elements have the same reference signs.

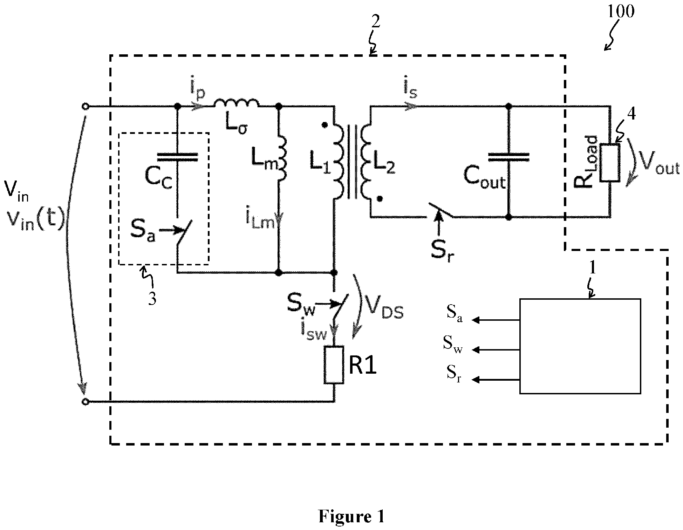

FIG. **1** shows an example of a control unit according to an embodiment of the invention for controlling a flyback converter and an example of such a flyback converter. The control unit of FIG. **1** is an example of the control unit according to the first aspect of the invention. Thus, the description of the control unit of the first aspect is correspondingly valid for the control unit of FIG. 1.

As shown in FIG. 1, the flyback converter comprises a transformer that galvanically isolates a primary side of the flyback converter from a secondary side of the flyback converter. The passages "primary side of the flyback converter" and "secondary side of the flyback converter" may be abbreviated using the terms "primary side" and "secondary side", respectively. The transformer comprises a primary winding L1 that is arranged on the primary side and a secondary winding L2 that is arranged on the secondary side. The passages "primary winding of the transformer" and "secondary winding of the transformer" may be abbreviated by "primary winding" and "secondary winding", respectively. In FIG. 1, the leakage inductance $L_\sigma$ and magnetizing inductance $L_m$ of the primary winding L1 are shown. On the primary side, a power switch $S_w$ is electrically connected in series with the primary winding L1, and an active clamp circuit 3 is electrically connected in parallel with the primary winding L1. The active clamp circuit 3 comprises a clamp switch

$S_a$ and a clamp capacitor $C_c$ that are electrically connected in series. The power switch $S_w$ and the clamp switch $S_a$ may be referred to as "(first) primary side switch" and "second primary side switch", respectively. The power switch $S_w$ and the clamp switch $S_a$ may be a transistor. For example, the power switch $S_w$ and the clamp switch $S_a$ are a transistor with a diode, such as a transistor with an intrinsic diode (e.g. a field-effect transistor (FET) having a body diode) or such as a transistor with a diode connected in anti-parallel to it (e.g. an insulated-gate bipolar transistor (IGBT) with a diode being connected in anti-parallel to it). For the following description of the invention it is assumed that the switches $S_w$ and $S_a$ are FETs, such as metal-oxide-semiconductor FETs (MOSFETs), having a body diode, wherein the drain terminal of the clamp switch $S_a$ being a FET is electrically connected (optionally via the clamp capacitor $C_c$, as shown in FIG. 1) with a first terminal of the converter for receiving an input voltage $V_{in}$ (e.g. AC voltage $V_{in}(t)$) and a first end of the primary winding L1 (according to the equivalent circuit of the primary winding L1 via the leakage inductance $L_\sigma$) and the source terminal of the switch $S_a$ is connected with a second end of the primary winding L1. The drain terminal and source terminal of the power switch $S_w$ being a FET is connected with the second end of the primary winding L1 and via an optional shunt resistor R1 to a second terminal for receiving the input voltage $V_{in}$.

The optional shunt resistor R1 is provided for measuring the current $i_{sw}$ flowing through the primary winding L1 and the power switch $S_w$ when the power switch $S_w$ is in the conducting state. The current $i_{sw}$ through the conducting power switch $S_w$ equals the current $i_p$ flowing through the primary winding L1 when the clamp switch $S_a$ is in the non-conducting state. The present invention is not limited to the shunt resistor R1 for current measurement and, thus, the current $i_p$ flowing through the primary winding L1 may be measured differently. The two terminals of the primary side for receiving an input voltage $V_{in}$ may be electrically connected with an external electrical energy source, such as mains, especially rectified mains.

On the secondary side, a first end of a capacitor $C_{out}$ (e.g. buffer capacitor) is connected with a first end of the secondary winding L2 and a second end of the capacitor $C_{out}$ is electrically connected via a secondary side switch $S_r$ with a second end of the secondary winding L2. The secondary side switch $S_r$ is configured to be switched for rectifying an AC voltage provided by the secondary winding L2. The secondary side switch $S_r$ may be a transistor. In case the secondary side switch $S_r$ is a transistor with a diode, such as a transistor with an intrinsic diode (e.g. a field-effect transistor (FET) having a body diode) or such as a transistor with a diode connected in anti-parallel to it (e.g. an insulated-gate bipolar transistor (IGBT) with a diode being connected in anti-parallel to it), it is possible to not switch the secondary switch $S_r$ for achieving rectification. In the aforementioned case the rectification may be achieved by the diode. The secondary side switch $S_r$ may be referred to as "rectifier switch". In the optional case of the secondary side switch $S_r$ being a FET, such as a MOSFET, the drain terminal and the source terminal of the secondary side switch $S_r$ may be connected with the secondary winding L2 and the capacitor $C_{out}$, respectively. The secondary side switch $S_r$ is merely an optional feature and, thus, rectification of the voltage provided by the secondary winding L2 on the secondary side may be achieved differently. For example, instead of the secondary side switch $S_r$ a diode may be electrically connected between the second end of the secondary winding L2 and the second end of the capacitor $C_{out}$. The two ends of the capacitor $C_{out}$ may be connected with two terminals of the flyback converter for providing an output voltage $V_{out}$ (DC voltage) to an electrical load $R_{Load}$, such as lighting means 4, the electrical load $R_{Load}$ (e.g. lighting means 4) may be connected with the two terminals of the secondary side for being electrically supplied by the flyback converter.

The control unit 1 of FIG. 1 is provided for controlling the flyback converter. The control unit 1 may control operation of the flyback converter by controlling switching of the power switch $S_w$ and the clamp switch $S_a$ on the primary side and the optional secondary side switch $S_r$ on the secondary side. For this, the control unit 1 may be configured to provide a control signal to each switch of the aforementioned switches. The control unit 1 may be or may comprise a microcontroller. In addition or alternatively, the control unit 1 may be or may comprise at least one of a controller, a microprocessor, a processor, an application specific integrated circuit (ASIC) and a field programmable gate array (FPGA).

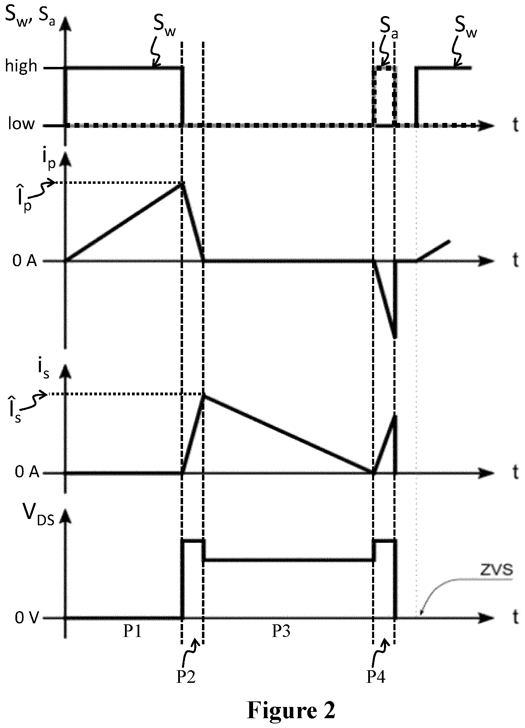

The control unit 1 may be configured to control the optional secondary side switch $S_r$ such that a rectification of the voltage provided by the secondary winding L2 is achieved. The present invention is not directed to methods for achieving rectification on the secondary side by the optional secondary side switch $S_r$. Therefore, this may be done as known in the art and no further details are provided on this in the following. As outlined already above, the secondary side switch $S_r$ is merely optional and may be replaced by a diode for achieving rectification. Additional control options of the optional secondary side switch $S_r$ known in the art may be carried out as long as they do not negatively influence the control of the primary side switches, i.e. the power switch $S_w$ and the clamp switch $S_a$. An example of a control of these two switches $S_w$ and $S_a$ by the control unit 1 is described below with regard to FIG. 2.

FIG. 2 shows an example of control signals provided by the control unit of FIG. 1 for controlling the flyback converter of FIG. 1 and currents and a voltage in the flyback converter caused by the control. In the graphs of FIG. 2, the horizontal axis indicates time t. The graph having the vertical axis labeled with "$S_w$, $S_a$" shows

control signals (e.g. in the form of voltages) that may be provided by the control unit 1 to the power switch $S_w$ and clamp switch $S_a$ in order to control switching of these two switches between the conducting and non-conducting state. The control signal for controlling switching of the power switch $S_w$ is shown by a solid line and the control signal for controlling switching of the clamp switch $S_a$ is shown by a dashed line. When the switches are FETs, such as MSOFETs, the control signals are provide to the gate terminal of the respective FET. As shown in FIG. 2, the control signals may have a high level and a low level (i.e. the control voltage may change between a high voltage level and a low voltage level). In case the control signal has a high level the switch, which is controlled by the control signal, is in the conducting state; and in case the control signal has a low level the switch is in the non-conducting state. According to FIG. 2, the control signal for controlling the power switch $S_w$ has a high level during the time (may also be referred to phase) P1 and a low level during the time P2, P3 and P4; and the control signal for controlling the clamp switch $S_a$ has a low level during the time P1, P2 and P3 and a high level during the time P4. The graph of FIG. 2 having the vertical axis labeled with "$i_p$" shows the electrical current $i_p$ (flowing) through the primary winding L1 as a result of the control of the primary side switches $S_w$ and $S_a$ by the control signals shown in the top graph of FIG. 2. The graph of FIG. 2 having the vertical axis labeled with "$i_s$" shows the electrical current $i_s$ (flowing) through the secondary winding L2 as a result of the control of the primary side switches $S_w$ and $S_a$ by the control signals shown in the top graph of FIG. 2. The graph of FIG. 2 having the vertical axis labeled with "$V_{DS}$" shows the electrical voltage across the power switch $S_w$ as a result of the control of the primary side switches $S_w$ and $S_a$ by the control signals shown in the top graph of FIG. 2.

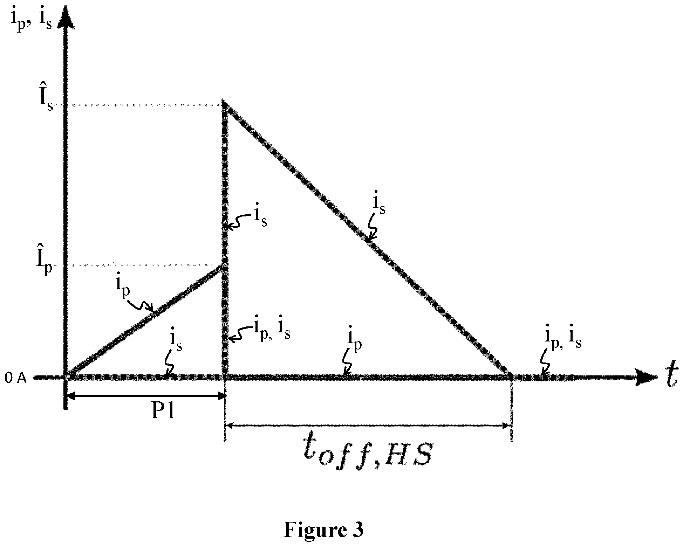

As shown in FIG. 2, during the time P1, the control unit 1 may control the power switch $S_w$ to be in the conducting state and the clamp switch $S_a$ to be in the non-conducting state. Thus, during the time P1 the current $i_p$ through the primary winding L1 rises and the primary winding L1 is charged. The control unit 1 may perform a maximum current control (i.e. peak current control) of the power switch $S_w$, so that the control unit 1 controls the power switch $S_w$ to switch from the conducting state to the non-conducting state at a point in time, at which the current $i_p$ flowing through the primary winding L1 and, thus, through the conducting power switch $S_w$ reaches a maximum current value $\hat{I}_p$. The control unit 1 may control the optional secondary side switch $S_r$ to be in the non-conducting state during the time P1 (not shown in FIG. 2). Optionally, the control unit 1 may control the optional secondary side switch $S_r$ to be in the non-conducting-state while the power switch $S_w$ is in the conducting state and vice versa. The control unit 1 may be configured to control the power switch $S_w$ and the optional secondary side switch $S_r$ such that they are not in the conducting state at the same time. As a result of switching the power switch $S_w$ from the conducting to the non-conducting state, during a time P2 electrical energy is transferred from the primary winding L1 to the secondary winding L2 and the control unit 1 may control the optional secondary side switch $S_r$ to switch from the non-conducting to the conducting state. During the time P2 the clamp capacitor $C_c$ may be charged through the body diode of the clamp switch $S_a$ with leakage energy from the transformer. As shown in FIG. 2, at the end of the time P2 the current $i_p$ through the primary winding L1 becomes zero Amperes (0 A) and the current $i_s$ through the secondary winding L2 equals to a second maximum current value $\hat{I}_s$ due to the energy transfer from the primary winding L1 to the secondary winding L2. The second maximum current value $\hat{I}_s$ depends on the maximum current value $\hat{I}_p$ of the current $i_p$ through the primary winding L1 and the winding ratio n between the primary winding L1 and secondary winding L2, i.e. the winding ratio n of the transformer. The winding ratio n equals the number N1 of windings of the primary winding L1 divided by the number N2 of windings of the secondary winding L2 ( $n = \frac{N1}{N2}$ ). The second maximum current value $\hat{I}_s$ may equal the maximum current value $\hat{I}_p$ multiplied by the winding ration n. Thus, in case the winding ratio is assumed to be greater than one (n > 1), the second maximum current value $\hat{I}_s$ is greater than the maximum current value $\hat{I}_p$ (this is not shown in FIG. 2, but in FIG. 3). After the time P2, the secondary side capacitor $C_{out}$ is charged with current from the secondary winding L2 so that the current $i_s$ through the secondary winding L2 decreases during a time P3, during which the primary side switches $S_w$ and $S_a$ are in the non-conducting state and the optional secondary side switch $S_r$ is in the conducting state. The time P3 may be referred to as "freewheeling interval" of the control of the flyback converter. The control unit **1** is configured to control the clamp switch $S_a$ from the non-conducting state to the conducting state at a point in time, at which the current $i_s$ through the secondary winding becomes zero Amperes (0 A). This point in time is the beginning of the time P4. During the time P4 the clamp switch $S_a$ is in the conducting state, i.e. at the end of the time P4 the control unit 1 controls the clamp switch $S_a$ to switch from the conducting to the non-conducting state. As a result of the clamp switch $S_a$ being in the conducting state (while the power switch $S_w$ is in the non-conducting state), the clamp capacitor $C_c$ may transfer the leakage energy (stored during the time P$_2$) from the primary winding L1 to the secondary winding L2 and, thus, the secondary side; and a negative current flow of the current $i_p$ flowing through the primary winding L1 (i.e. the current $i_p$ flows in opposite direction compared to the direction of flow during the time P1) discharges the output capacitance of the power switch $S_w$. The transfer of the leakage energy from the clamp capacitor $C_c$ to the secondary winding L2 during the time P4 is represented in FIG. 2 by the increase of the current $i_s$ through the secondary winding L2 during the time P4. The negative current flow of the current $i_p$ through the primary winding L1 during the time P4 is represented in FIG. 2 by the negative current $i_p$ (with increasing absolute value) through the primary winding L1 during the time P4. The discharging of the output capacitance of the power switch $S_w$ during the time P4 is represented in FIG. 2 by the decrease of the voltage $V_{DS}$ across the power switch $S_w$ (i.e. the drain-source voltage of the FET) to zero Volts (0 V). This allows zero voltage switching (ZVS) for switching the power switch $S_w$ again from the non-conducting to the conducting state. This occurs after a certain time after the end of the time P4, as indicated in FIG. 2. By switching the power switch $S_w$ multiple times to the conducting and non-conducting state, as exemplarily shown for one period of switching in Figure 2, the control unit may control the electrical energy transfer from the primary side to the secondary side via the transformer and, thus, an amount of electrical energy (e.g. the average electrical energy over time) provided by the flyback converter at the secondary side to the electrical load, e.g. lighting means 4. For example, the output current provided at the secondary side of the flyback converter may be controlled by the winding ratio n, the maximum current value $\hat{I}_p$ for the current $i_p$ through the primary winding, and a waiting time $t_{off,HS}$, wherein the clamp switch $S_a$ is switched from the non-conducting state to the conducting state when the waiting time $t_{off,HS}$ has elapsed after switching the power switch $S_w$ from the conducting state to the non-conducting state. The greater the maximum current value $\hat{I}_p$ and/or the greater the winding ration n, the greater may be the second maximum current value $\hat{I}_s$ and vice versa. The control unit 1 may be configured to perform a Boundary Conduction Mode (BCM) for controlling the power switch $S_w$.

The control unit 1 of FIG. 1 is configured to control switching of the clamp switch $S_a$ as outlined above and shown in FIG. 2 without measuring the current $i_s$ through the secondary winding L2 during the time P3 and P4, without measuring the voltage $V_{DS}$ across the power switch $S_w$ and without measuring the negative current $i_p$ through the primary winding L1 while the power switch $S_w$ is in the non-conducting state during the time P4. That is, the control unit 1 of FIG. 1 is configured to control the clamp switch $S_a$ without the aforementioned measurements such that the clamp switch $S_a$ is switched from the non-conducting state to the conducting state at a point in time, at which the current through the secondary winding L2 reaches zero Amperes (0 A) and, thus, achieving zero current switching.

For achieving this, the control unit 1 is configured to compute a waiting time $t_{off,Hs}$ using an inductance of the primary winding L1 of the transformer of the flyback converter, the maximum current value $\hat{I}_p$ (for the current $i_p$ through the primary winding L1 and, thus, the conducting power switch $S_w$), the winding ratio n of the transformer and the output voltage $V_{out}$ of the flyback converter. The control unit 1 is configured to switch the clamp switch $S_a$ from the non-conducting state to the conducting state when the waiting time $t_{off,HS}$ has elapsed after switching the power switch $S_w$ from the conducting state to the non-conducting state. This is exemplarily shown in FIG. 3.

FIG. 3 shows an example of a current flowing through the primary winding and a current flowing through the secondary winding of the flyback converter of FIG. 1 during a part of a control cycle of switching the flyback converter. Especially, in FIG. 3 the time P1 and P3 of FIG. 2 are shown (without the time P2 of FIG. 2). In FIG. 3, the solid line indicates the current $i_p$ through the primary winding L1 and the dashed line indicates the current $i_s$ through the secondary winding L2. Since the time P2 of FIG. 2 is much shorter compared to the times P1 and P3 it is not shown in FIG. 3 and may be neglected for the following description. In FIG. 3, it is exemplarily assumed that the winding ratio n of the transformer is greater than one (n > 1) and, thus, the second maximum current value $\hat{I}_s$ is greater than the maximum current value $\hat{I}_p$ used for switching the power switch $S_w$ from the conducting to the non-conducting state at a point in time, at which the current $i_p$ reaches the maximum current value $\hat{I}_p$. As indicated in FIG. 3, the waiting time $t_{off,Hs}$ may be computed by the control unit 1 such that when the waiting time $t_{off,Hs}$ has elapsed after the point in time, at which the current $i_p$ through the primary winding L1 reaches the maximum current value $\hat{I}_p$ and, thus, the control unit 1 switches the power switch $S_w$ from the conducting to the non-conducting state, the current $i_s$ through the secondary winding has reached zero Amperes (0 A).

In order for this to be the case, the control unit 1 may be configured compute the waiting time $t_{off,HS}$ such that the waiting time $t_{off,HS}$ equals a product of an inductance $L_1$ of the primary winding L1 of the transformer and the maximum current value $\hat{I}_p$ divided by a product of the winding ratio n of the transformer and the output voltage $V_{out}$ of the flyback converter ($t_{off,HS} = (L_1 \times \hat{I}_p)/(n \times V_{out})$). As shown in FIG. 1, the primary winding L1 has a leakage inductance $L_\sigma$ and magnetizing inductance $L_m$. Since the leakage inductance $L_\sigma$ is much smaller than the magnetizing inductance $L_m$, it may be neglected and, thus, the magnetizing inductance $L_m$ may be used as the inductance $L_1$ of the primary winding L1 of the transformer for computing the waiting time $t_{off,HS}$.

In other words, Farraday's inductance law may be used by the control unit 1 for computing the waiting time $t_{off,HS}$. The following equations describe how the decrease of the current $i_s$ through the secondary winding L2 that charges the secondary side capacitor $C_{out}$ and, thus, the zero crossing of the current $i_s$ may be considered by the above described computation:

$$u_{L2} = L_2 \times \frac{di_s}{dt} \qquad (1)$$

$$V_{out} = L'_m \times \frac{\hat{I}_s}{t_{off,HS}} \qquad (2)$$

$$V_{out} = \frac{L_m}{n^2} \times \frac{n \times \hat{I}_p}{t_{off,HS}} \qquad (3)$$

$$t_{off,HS} = (L_m \times \hat{I}_p)/(n \times V_{out}) \qquad (4)$$

In above equation (1), the voltage $u_{L2}$ across the secondary winding L2 equals the inductance $L_2$ of the secondary winding L2 multiplied by the change in current through the secondary winding $\left(\frac{di_s}{dt}\right)$. As may be derived from the circuit of FIG. 1, the voltage across the secondary winding L2 equals the voltage $V_{out}$ across the secondary side capacitor $C_{out}$ (assuming that the voltage drop across the optional secondary side switch $S_r$ is negligible). Moreover, as outlined already above with regard to the primary winding L1, the leakage inductance $L'_\sigma$ of the secondary winding L2 is much smaller than the magnetizing inductance $L'_m$ so that it may be neglected and, thus, the magnetizing inductance $L'_m$ may be used as the inductance of the secondary winding L2. As shown in FIGs. 2 and 3, the change of the current $i_s$ through the secondary winding L2 (i.e. the decreasing of said current $i_s$) corresponds to the slope of the curve indicating the current $i_s$. Since the current $i_s$ should decrease from the second maximum current value $\hat{I}_s$ to zero Amperes during the waiting time $t_{off,HS}$, the change of the current $i_s$ may be computed by dividing the second maximum current $\hat{I}_s$ by the waiting time $t_{off,HS}$ $\left(\frac{di_s}{dt} = \frac{\hat{I}_s}{t_{off,HS}}\right)$. Using the winding ratio n of the transformer allows rewriting above equation (2) with regard to the primary winding L1, i.e. using the magnetizing inductance $L_m$ of the primary winding L1 and the maximum current value $\hat{I}_p$ for the current $i_p$ through the primary winding L1, as shown in equations (3) and (4).

For controlling switching of the clamp switch $S_a$ from the conducting-state to the non-conducting state, the control unit 1 may be configured to switch the clamp switch $S_a$ from the conducting state to the non-conducting state when a switch-on time has elapsed after switching the clamp switch from the non-conducting state to the conducting state, and obtain (optionally select), in dependence of the input voltage $V_{in}$ and an output power of the flyback converter, the switch-on time from different switch-on times associated with pairs of different values of the input voltage and the output power.

In other words, the control unit 1 may be configured to switch the clamp switch $S_a$ back to the non-conducting state after an switch-on time has elapsed starting with the point in time, at which the control unit 1 switches the clamp switch $S_a$ to the conducting state. That is, the switch-on time starts at a point in time, at which the waiting time $t_{off,Hs}$ has elapsed. Namely, elapsing of the waiting time $t_{off,HS}$ causes the control unit 1 to switch the clamp switch $S_a$ from the non-conducting state to the conducting state.

The different switch-on times of the clamp switch $S_a$ associated with the pairs of different values of the input voltage and the output power may be generated by measuring an optimal switch-on time for each of the pairs of different values of the input voltage and the output power. In addition or alternatively, the different switch-on times associated with the pairs of different values of the input voltage and the output power may be generated by simulating an optimal switch-on time for each of the pairs of different values of the input voltage and the output power.

Measuring or simulating the switch-on time of the clamp switch $S_a$ may correspond to measuring or simulating, respectively, the duty cycle of the control signal for controlling the clamp switch $S_a$. Namely, the duty cycle equals the switch-on time divided by the sum of the switch-on time and the switch-off time of the clamp switch $S_a$. The switch-on time and switch-off time of a switch, such as the clamp switch $S_a$, is the time during which the switch is in the conducting state and the time during which the switch is in the non-conducting state, respectively. The sum of the switch-on time and the switch-off time of a control signal may be the period (i.e. the inverse of the frequency) of the control signal.

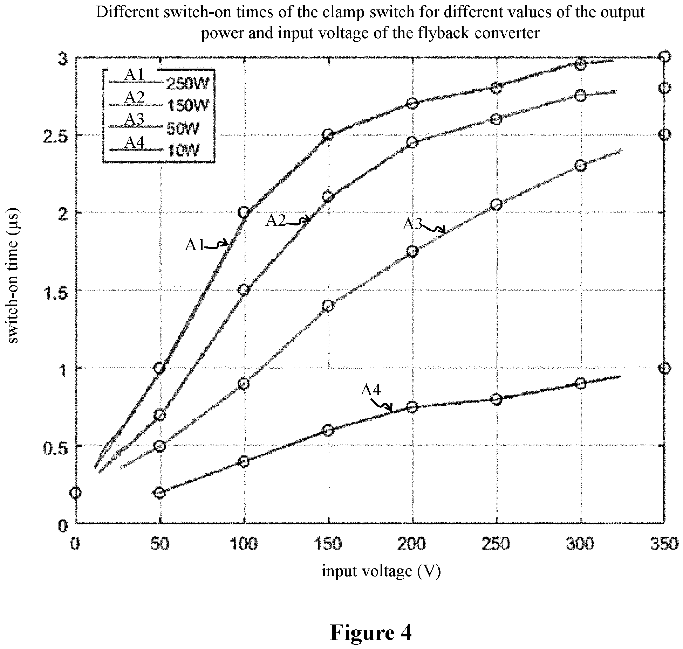

FIG. 4 shows an example of different switch-on times of the clamp switch of the flyback-converter of FIG. 1 for different values of the output power and input voltage of the flyback converter.

The vertical axis of the graph of FIG. 4 represents the switch-on time of the clamp switch $S_a$ in μs, the horizontal axis represents the input voltage $V_{in}$ in Volts (V). The different curves A1, A2, A3, A4 show the relationship between the switch-on time and the input voltage $V_{in}$ for different output powers, wherein curve A1, A2, A3 and A4 shows the aforementioned relationship for an output power of 250 Watt (W), 150 W, 50 W and 10 W, respectively. By using the data shown in the graph of FIG. 4, i.e. the pairs of different values of the input voltage and the output power, the optimal switch-on time for a pair of values of the input voltage and the output power may be used. That is, the control unit 1 may be configured to determine based on the input voltage and the output power that is present at the time of control, e.g. when switching the clamp switch $S_a$ from the non-conducting state to the conducting state, the actual input voltage $V_{in}$ and actual output power and use these determined values to obtain, optionally select, the corresponding optimal switch-on time from the previously measured and/or simulated data. The control unit 1 may be configured to measure the input voltage $V_{in}$ using a respective measurement element arranged on the primary side of the flyback converter, such as a voltage divider. In case the flyback converter is supplied from an AC electrical energy source, such as mains, the control unit 1 may use as the input voltage the rectified AC voltage, e.g. rectified mains voltage. The control unit 1 may be configured to obtain (e.g. measure) the output power of the flyback converter. Optionally, the control unit 1 may be configured to obtain (e.g. measure) the output voltage and/or output current and compute the output power.

The present invention may be differently implemented with regard to obtaining the input voltage $V_{in}$ and/or the output power.

The control unit 1 may be configured to obtain, optionally select, the switch-on time from the different switch-on times associated with pairs of different values of the input voltage and the output power (previously generated by simulation), by fitting the actual input voltage and output power with the aforementioned values (e.g. the values from the simulation). For example, with regard to the simulation results shown in FIG. 4, the control unit may use a second order polynomial to fit the actual input voltage and output power within one power or between powers.

The control unit may compute, using a higher order equation, the switch-on time using the different switch-on times associated with pairs of different values of the input voltage and the output power.

For example, with regard to an output power of the data and, thus, the respective curve (e.g. curve A4 in case of an output power of 10 W), the control unit may compute the switch-on time by making a best-fit on the curves of FIGs. 4, i.e. the data of the multiple curves. For example, the control unit may obtain the input voltage $V_{in}$ and compute the switch-on time $t_{on,Sa}$ with a second order equation $t_{on,Sa} = V_{in}^2 \times a + V_{in} \times \phantom{x} \times b + c$. The parameters a, b and c are the results of a best fit calculation. The control unit may make a best fit between the multiple curves, i.e. between the different output powers associated to the multiple curves, respectively.

The control unit may store the different switch-on times of the clamp switch $S_a$ associated with the pairs of different values of the input voltage $V_{in}$ and the output power. In addition or alternatively, the control unit 1 may be configured to obtain from a data storage the different switch-on times associated with the pairs of different values of the input voltage $V_{in}$ and the output power.

The control unit 1 may be configured to perform a power factor correction (PFC) function by changing the maximum current value $\hat{I}_p$ (for control switching the power switch $S_w$ to the non-conducting state when the current $i_p$ through the primary winding L1 reaches this maximum current value $\hat{I}_p$) such that a shape of an envelope of the changing maximum current value $\hat{I}_p$ has a sinusoidal form of the input voltage $V_{in}$ of the flyback converter. In the aforementioned case, the input voltage $V_{in}$ may be an AC voltage $V_{in}(t)$, e.g. provided from mains.

The flyback converter of FIG. 1 and the control unit 1 of FIG. 1 may be part of an operating device 2 for lighting means 4. The operating device 2 of FIG. 1 is an example of the operating device according to the second aspect of the invention. Thus, the description of the operating device according to the second aspect is correspondingly valid for the operating device 2 of FIG. 1 The lighting means 4 are optionally one or more light emitting diodes (LEDs). The control unit 1 and the flyback converter may be arranged inside a housing (indicated by the dashed box in FIG. 1) of the operating device 2. In case the lighting means 4 are LED(s), the operating device may be referred to as "LED operating device" or "LED driver". The terms "driver" and "gear" may be used as synonyms for the term "operating device".

The operating device 2 and the lighting means 4 may be part of a lighting system 100, wherein the operating device 2 is configured to electrically supply the lighting means 4. The lighting system 100 of FIG. 1 is an example of the lighting system according to the third aspect of the invention. Thus, the description of the lighting system according to the third aspect is correspondingly valid for the lighting system 100 of FIG. 1. Optionally, the lighting system is a luminaire. The operating device 2 and the lighting means 4 may be arranged inside a housing of the luminaire (not shown in FIG. 1). Optionally, the lighting means may be arranged at least partly outside the housing, e.g. protrude out of the housing.

The above functions of the control unit 1 may be a method for controlling a flyback converter such as the flyback converter of FIG. 1. The control unit 1 may be configured to perform such a method for controlling operation of the flyback converter. Such method is an example of the method of the fourth aspect of the invention. Thus, the description of the method of the fourth aspect of the invention is correspondingly valid for such method.

The present invention allows using a flyback converter with an ACF topology as a single PFC power converter stage, even for higher power (e.g. >60 W), as the invention proposes a control unit for controlling the operation of such single converter stage. This is advantageous with regard to costs and space, as a single power converter stage causes less costs and consumes less space compared to multiple stages. Further, the invention allows a low-cost microcontroller for implementing the control unit. Furthermore, the control unit of the present invention does not require additional current sensing for detecting zero crossing of the current $i_s$ flowing through the secondary winding L2 of the flyback converter in order to be able to control switching the clamp switch $S_a$ from the non-conducting state to the conducting state while achieving zero current switching. This reduces component costs, manufacturing costs and required space.

In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

**Claims**

1. A control unit (1) for controlling a flyback converter comprising a power switch ($S_w$) and an active clamp circuit (3) having a clamp switch ($S_a$), wherein the control unit (1) is configured to

   - switch the clamp switch ($S_a$) from the non-conducting state to the conducting state when a waiting time ($t_{off,HS}$) has elapsed after switching the power switch ($S_w$) from the conducting state to the non-conducting state,
   - switch the power switch ($S_w$) from the conducting state to the non-conducting state when a current ($i_p$) flowing through the power switch ($S_w$) being in the conducting state reaches a maximum current value ($\hat{I}_p$), and
   - compute the waiting time using an inductance of a primary winding (L1) of a transformer of the flyback converter, the maximum current value ($\hat{I}_p$), a winding ratio of the transformer and an output voltage ($V_{out}$) of the flyback converter.

2. The control unit (1) according to claim 1, wherein

   - the control unit (1) is configured to compute the waiting time such that the waiting time equals a product of an inductance ($L_m$) of the primary winding (L1) of the transformer and the maximum current value ($\hat{I}_p$) divided by a product of the winding ratio of the transformer (n) and the output voltage ($V_{out}$) of the flyback converter.

3. The control unit (1) according to any one of the previous claims, wherein the control unit (1) is configured to

   - switch the clamp switch ($S_a$) from the conducting state to the non-conducting state when a switch-on time has elapsed after switching the clamp switch ($S_a$) from the non-conducting state to the conducting state, and
   - obtain, in dependence of an input voltage ($V_{in}$) and an output power of the flyback converter, the switch-on time from different switch-on times associated with pairs of different values of the input voltage ($V_{in}$) and the output power.

4. The control unit (1) according to claim 3, wherein at least one of the following is true:

   - the control unit (1) stores the different switch-on times associated with the pairs of different values of the input voltage ($V_{in}$) and the output power,
   - the control unit (1) is configured to obtain from a data storage the different switch-on times associated with the pairs of different values of the input voltage ($V_{in}$) and the output power, and
   - the control unit (1) is configured to compute, using a higher order equation, the switch-on time using the different switch-on times associated with pairs of different values of the input voltage ($V_{in}$) and the output power.

5. The control unit (1) according to any one of the previous claims, wherein

   - the control unit (1) is configured to perform a power factor correction, PFC, function by changing the maximum current value ($\hat{I}_p$) such that a shape of an envelope of the changing maximum current value ($\hat{I}_p$) has a sinusoidal form of an input voltage ($V_{in}$) of the flyback converter.

6. An operating device (2) for lighting means (4), optionally one or more light emitting diodes, LEDs, wherein the operating device (2) comprises

   - a control unit (1) according to any one of the previous claims, and
   - a flyback converter comprising a power switch ($S_w$) and an active clamp circuit (3) having a clamp switch ($S_a$), wherein
   - the control unit (1) is configured to control switching of the power switch ($S_w$) and the clamp switch ($S_a$) of the flyback converter.

7. The operating device (2) according to claim 6, wherein

   - the active clamp circuit (3) comprises a clamp capacitor ($C_c$), and
   - the clamp capacitor ($C_c$) and the clamp switch ($S_a$) are electrically connected in series.

8. The operating device (2) according to claim 6 or 7, wherein

   - the power switch ($S_w$) is electrically connected in series with a primary winding (L1) of a transformer of the flyback converter, and
   - the active clamp circuit (3) is electrically connected with the primary winding (L1) of the transformer in parallel.

9. A lighting system (100) comprising

   - an operating device (2) according to any one of claims 6 to 8, and
   - lighting means (4), wherein
   - the operating device (2) is configured to electrically supply the lighting means (4).

10. A method for controlling a flyback converter comprising a power switch ($S_w$) and an active clamp circuit (3) having a clamp switch ($S_a$), wherein the method comprises

- switching the clamp switch ($S_a$) from the non-conducting state to the conducting state when a waiting time has elapsed after switching the power switch ($S_w$) from the conducting state to the non-conducting state,
- switching the power switch ($S_w$) from the conducting state to the non-conducting state when a current ($i_p$) flowing through the power switch ($S_w$) being in the conducting state reaches a maximum current value ($\hat{I}_p$), and
- computing the waiting time using an inductance of a primary winding (L1) of a transformer of the flyback converter, the maximum current value ($\hat{I}_p$), a winding ratio of the transformer and an output voltage ($V_{out}$) of the flyback converter.

11. The method according to claim 10, wherein

- the method comprises computing the waiting time such that the waiting time equals a product of an inductance ($L_m$) of the primary winding (L1) of the transformer and the maximum current value ($\hat{I}_p$) divided by a product of the winding ratio (n) of the transformer and the output voltage (Vout) of the flyback converter.

12. The method according to claim 10 or 11, wherein the method comprises

- switching the clamp switch ($S_a$) from the conducting state to the non-conducting state when a switch-on time has elapsed after switching the clamp switch ($S_a$) from the non-conducting state to the conducting state, and
- obtaining, in dependence of an input voltage ($V_{in}$) and an output power of the flyback converter, the switch-on time from different switch-on times associated with pairs of different values of the input voltage ($V_{in}$) and the output power.

13. The method of claim 12, wherein the method comprises

- generating the different switch-on times associated with the pairs of different values of the input voltage ($V_{in}$) and the output power by

  - measuring an optimal switch-on time for each of the pairs of different values of the input voltage ($V_{in}$) and the output power, and/or
  - simulating an optimal switch-on time for each of the pairs of different values of the input voltage ($V_{in}$) and the output power.

14. The method according to claim 12 or 13, wherein the method comprises

- obtaining from a data storage the different switch-on times associated with the pairs of different values of the input voltage ($V_{in}$) and the output power and/or
- computing, using a higher order equation, the switch-on time using the different switch-on times associated with pairs of different values of the input voltage ($V_{in}$) and the output power.

15. The method according to any one of claims 10 to 14, wherein

- the method comprises performing a power factor correction, PFC, function by changing the maximum current value ($\hat{I}_p$) such that a shape of an envelope of the changing maximum current value ($\hat{I}_p$) has a sinusoidal form of an input voltage ($V_{in}$) of the flyback converter.

**Figure 1**

**Figure 2**

**Figure 3**

Different switch-on times of the clamp switch for different values of the output
power and input voltage of the flyback converter

**Figure 4**

Europäisches
Patentamt
European
Patent Office
Office européen
des brevets

**EUROPEAN SEARCH REPORT**

Application Number

EP 24 19 9925

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 113 098 280 B (UNIV SOUTHEAST) 5 April 2022 (2022-04-05) * figures 1, 2, 4 * | 1-15 | INV. H02M1/00 H02M1/34 H02M1/42 H02M3/335 H05B45/385 |
| A | SHI YONG ET AL: "A DCM Interleaved Flyback Micro-Inverter with New Auxiliary Active Clamp Branch Design for Zero-Voltage Switching Effect", 2024 ENERGY CONVERSION CONGRESS & EXPO EUROPE (ECCE EUROPE), IEEE, 2 September 2024 (2024-09-02), pages 1-6, XP034754491, DOI: 10.1109/ECCEEUROPE62508.2024.10752055 [retrieved on 2024-11-20] * Chapters III.A and III.B; figures 5-7 * | 1-15 | ADD. G01R27/26 |
| A | US 2018/294734 A1 (SONG HAIBIN [CN] ET AL) 11 October 2018 (2018-10-11) * paragraph [0046] * * paragraph [0064] - paragraph [0066] * * figures 1, 8-14 * | 1-15 | |
| A | US 2022/052612 A1 (LIN TZU-CHEN [TW]) 17 February 2022 (2022-02-17) * figures 1-6 * | 1-15 | TECHNICAL FIELDS SEARCHED (IPC) H02M G01R H05B |

The present search report has been drawn up for all claims

| Place of search | Date of completion of the search | Examiner |
|---|---|---|
| The Hague | 11 February 2025 | Madouroglou, E |

CATEGORY OF CITED DOCUMENTS

X : particularly relevant if taken alone
Y : particularly relevant if combined with another
　document of the same category
A : technological background
O : non-written disclosure
P : intermediate document

T : theory or principle underlying the invention
E : earlier patent document, but published on, or
　after the filing date
D : document cited in the application
L : document cited for other reasons

.......................................................................

& : member of the same patent family, corresponding
　document

EPO FORM 1503 03.82 (P04C01)

## ANNEX TO THE EUROPEAN SEARCH REPORT
## ON EUROPEAN PATENT APPLICATION NO.

EP 24 19 9925

This annex lists the patent family members relating to the patent documents cited in the above-mentioned European search report.
The members are as contained in the European Patent Office EDP file on
The European Patent Office is in no way liable for these particulars which are merely given for the purpose of information.

11-02-2025

| Patent document cited in search report | | Publication date | Patent family member(s) | Publication date |
|---|---|---|---|---|
| CN 113098280 | B | 05-04-2022 | NONE | |
| US 2018294734 | A1 | 11-10-2018 | NONE | |
| US 2022052612 | A1 | 17-02-2022 | NONE | |

EPO FORM P0459

For more details about this annex : see Official Journal of the European Patent Office, No. 12/82